(19)

Europäisches
Patentamt
European
Patent Office
Office européen
des brevets

(11) **EP 2 897 158 A1**

(12) **EUROPEAN PATENT APPLICATION**
published in accordance with Art. 153(4) EPC

(43) Date of publication:
**22.07.2015 Bulletin 2015/30**

(21) Application number: **13874680.5**

(22) Date of filing: **13.09.2013**

(51) Int Cl.:
*H01L 21/205* (2006.01)          *H01L 33/30* (2010.01)
*H01L 31/0304* (2006.01)          *H01L 31/18* (2006.01)

(86) International application number:
**PCT/RU2013/000796**

(87) International publication number:
**WO 2014/123448 (14.08.2014 Gazette 2014/33)**

(84) Designated Contracting States:
**AL AT BE BG CH CY CZ DE DK EE ES FI FR GB
GR HR HU IE IS IT LI LT LU LV MC MK MT NL NO
PL PT RO RS SE SI SK SM TR**
Designated Extension States:
**BA ME**

(30) Priority: **14.09.2012 EA 201201245**

(71) Applicant: **Limited Liability Company "LED
Microsensor NT"
St. Petersburg 194021 (RU)**

(72) Inventor: **Kizhaev, Sergei Sergeevich
St. Petersburg 197371 (RU)**

(74) Representative: **Grünecker Patent- und
Rechtsanwälte
PartG mbB
Leopoldstraße 4
80802 München (DE)**

(54) **PRODUCING HETEROSTRUCTURES (VARIANTS) FOR THE MID-INFRARED RANGE**

(57)     The present invention relates to a technique of producing spontaneous radiation sources on the basis on $A^{III}B^{V}$ semiconductor compounds for the spectral range of 2.6 - 4.7 $\mu$m, and to a technology of producing photosensitive structures for the spectral range of 2.0 - 4.7 $\mu$m. In the first embodiment, the heterostructure comprises a substrate containing InAs, a barrier layer which contains InSbP and which is arranged on the substrate, and an active layer which contains InAsSbP and which is arranged on the barrier layer. Light-emitting diodes produced on the basis of the first embodiment of the heterostructure emit at a wavelength in the range of 2.6 - 3.1 $\mu$m. In the second embodiment, the heterostructure comprises a substrate containing InAs, an active area which contains InAsSb and which is arranged on the substrate, and a barrier layer which contains InSbP and which is arranged on the active area. The active area can comprise a InAsSb bulk active layer, InAs/InAsSb quantum wells or a GaInAs/InAsSb strained superlattice. Light-emitting diodes produced on the basis of the second embodiment of the heterostructure emit at a wavelength in the range of 3.1- 4.7pm, and photodiodes have broadband sensitivity in the range of 2.0 - 4.7 $\mu$m. In the method of producing a heterostructure, tert-butylarsine is used as a source of arsenic, and tert-butylphosphine is used as a source of phosphorus.

EP 2 897 158 A1

**Description**

FIELD OF THE INVENTION

The present invention relates to a technology of producing spontaneous radiation sources on the basis of $A^{III}B^{V}$ semiconductor compounds for the spectral range of 2.6 - 4.7 $\mu$m, and to a technology of producing the photosensitive structures for the spectral range of 2.0 - 4.7 $\mu$m. The light-emitting diodes produced on the basis of the provided heterostructures emit radiation in the mid-infrared range of 2.6 - 4.7 $\mu$m, and photodiodes have broadband photosensitivity in the range of 2.0 - 4.7 $\mu$m. The provided method of producing heterostructures, the light-emitting diode and the photodiode based on the eterostructure provide significant advantages when they are used to produce sensors configured to be applied for gas analysis. In particular, the sensors can be used for monitoring an environment, for controlling technological processes, e.g. for determining carbon dioxide (absorbing radiation in the range of 2.64 - 2.87 $\mu$m at wavelength of 4.27 $\mu$m) and hydrogen sulfide (absorbing radiation at wavelength of 2.63 $\mu$m) in living spaces and industrial constructions. The radiation range of 2.6 - 4.7 $\mu$m includes primary characteristic absorption bands of the CH-group, in particular of such compounds as methane and alcohols. Furthermore, mid-infrared sensors can be used in medical diagnostics, e.g. for light spectroscopy as used to analyze concentration of carbon dioxide, acetone and other compounds in exhaled air. Further, the range of 2.65 - 2.85 $\mu$m includes primary characteristic absorption bands of water and water vapors. The present invention is not limited to aforementioned examples, and the heterostructure and light-emitting diodes based thereon can be used in any other applications where there is requirement to determine presence and/or concentration of compounds with absorption bands in the mid-infrared range of 2.6 - 4.7 $\mu$m, and in the range of 2.0 - 4.7 $\mu$m for photodiodes.

BACKGROUND OF THE INVENTION

Known infrared optical sensors based on heat infrared radiation sources are produced by PerkinElmer, TexasInstruments, CityTechnology and other companies. Such sources emit radiation in a broad spectral range, and then narrowband optical filters isolate a required wavelength range.

The disadvantage of prior art optical sensors is in that they require use of optical filters. Furthermore, prior art optical sensors have some other disadvantages, such as high power consumption, low-speed performance, bulky dimensions and limited lifetime of a heat source.

The above disadvantages of the prior art infrared optical sensors based on heat infrared radiation sources can be overcomed by using light-emitting diodes and photodiodes operating in a mid-infrared range.

A technology of producing light-emitting diodes and photodiodes for visible and near infrared spectral ranges on the basis of GaN, GaAs and InP is well-developed. Such devices have the internal quantum efficiency values close to 1. However, it is much more difficult to achieve high quantum efficiency in a mid-infrared range. The internal quantum efficiency values of light-emitting diodes operating in a wavelength range of about 3 $\mu$m are lower in 4 to 5 times. Narrowbandgap compounds based on InAs have a high charge carrier diffusion length (about 25 $\mu$m for electrons) and possess lower radiative recombination efficiency and higher intensity of nonradiative processes.

A semiconductor diode for a near-infrared spectral range (Russian Federation patent No. 2286618, IPC H01L 33/00, H01L 31/12) comprises p- and n-areas with current-conducting contacts divided by a p-n junction, an active area electrically associated with the p-n junction, and at least one optical module optically associated with the active area via an optical compound.

A disadvantage of prior art semiconductor diode is the limited wavelength range of 1.22 - 1.24 $\mu$m where the prior art diode can emit. The radiation wavelength of the prior art diode is determined by the diode structure, wherein the diode comprises a $n^{+}$-InP substrate with an active layer containing a InGaAsP solid solution grown thereon. In another embodiment, the prior art semiconductor diode comprises a $n^{+}$-InAs substrate with a n-InAsSbP/n-InGaAs-p/p-InAsSbP double heterostructure grown thereon. Said diode emits at a wavelength of 3.4 $\mu$m. In yet another embodiment, the prior art semiconductor diode comprises a n-InAs substrate with a n-InAsSbP/n-InGaAsSb/p-InAsSbP double heterostructure grown thereon. Said diode emits at a wavelength of 3.9 $\mu$m. Therefore, the above heterostructures cannot be used to obtain diodes emitting in the range of 2.6 - 3.3 $\mu$m. Furthermore, the prior art semiconductor diodes cannot be used to determine presence and/or concentration of compounds (such as water and water vapors, carbon dioxide, hydrogen sulfide) with characteristic absorption bands falling within said range.

Furthermore, the prior art diodes are formed by using a liquid-phase epitaxy technique. The disadvantage of the liquid-phase epitaxy technique is ithe practical complexity in growing heterostructures of small dimensions required to grow bulk layers. Furthermore, the liquid-phase epitaxy technique is unsuitable for growing InAsSbP solid solutions across the whole range of compositions due to the presence of immiscibility regions.

Yet another disadvantage of the prior art diode is the use of an optical module and an optical compound, which complicates the technique of producing diode and increases the risk of defects at the process stage of coupling the optical module to the LED chip.

Further, light-emitting diodes based on InAsSbP solid solutions (T.N. Danilova, A.N. Imenkov, K.D. Moiseev, I.N. Timchenko, Yu.P. Yakovlev: "Light-emitting diodes based on InAsSbP for the spectral range of 2.6 - 3.0 $\mu$m (T = 300K)"; Letters to the Technical Physics Journal, 1994, vol. 20, issue 10, p. 20-24) are known in the art. The structure of the prior art light-emitting diode grown by a liquid-phase epitaxy technique comprises a n-InAs substrate, an n-type wide-band layer containing InAsSbP, a p-type active layer containing InAsSbP, and a p-type wide-band layer containing InAsSbP. The quantum efficiency of radiation emitted by prior art light-emitting diodes does not exceed 0.02 - 0.03% at a room temperature with 50 mA current. Phosphorus content in wide-band areas does not exceed 30%.

A disadvantage of prior art light-emitting diodes is low quantum efficiency.

Further, light-emitting diodes based on InAsSbP solid solutions (V.V. Romanov, E.V. Ivanov, A.N. Imenkov, N.M. Kolchanova, K.D. Moiseev, N.D. Stoyanov, Yu.P. Yakovlev: "Light-emitting diodes based on InAsSbP limiting composition solid solutions for spectral range of 2.6 - 2.8 $\mu$m"; Letters to the Technical Physics Journal, 2001, vol. 27, issue 14, p. 8087) are known in the art. The structures for the prior art light-emitting diodes are provided by using a liquid-phase epitaxy technique. The prior art emitting structure comprises a p-InAs substrate with a p-type barrier layer containing InAsSbP, an active layer containing InAsSbP, and an n-type barrier layer containing InAsSbP consequently grown thereon. The spinodal decomposition area and molecularity condition limitation lead to the formation of a large area of InAsSbP solid solution compositions, which is inaccessible for crystallization using near-equilibrium methods, i.e. liquid-phase epitaxy techniques, which does not provide conditions for effective charge carrier retention in the active area of the diode. The InP content in barrier layers of prior art light-emitting diodes grown using a liquid-phase epitaxy technique does not exceed 32%, and said value is defined as the theoretical limit, and therefore, when using the liquid-phase epitaxy technique, the light-emitting diode efficiency cannot be increased by increasing barrier height at the heterointerface between the barrier layer and the active layer.

Further, light-emitting diodes with a wavelength of 3.3 - 3.4 $\mu$m (A.P. Astakhova, A.S. Golovin, N.D. Ilyinskaya, K.V. Kalinina, S.S. Kizhaev, O.Yu. Serebrennikova, N.D. Stoyanov, Zs.J. Horvath, Yu.P. Yakovlev: "Powerful light-emitting diodes based on InAs/InAsSbP heterostructures for methane spectroscopy ($\lambda$≈3.3 $\mu$m)"; Semiconductor physics and technology, 2010, vol. 44, issue 2, p. 278284) are known in the art. The method of producing heterostructures disclosed in the above publication is considered prior art for the present invention. The prior art light-emitting diodes are configured on the basis of a heterostructure, the heterostructure comprising: a substrate containing InAs, a first barrier layer containing InAsSbP, and an active layer containing InAs. Furthermore, the heterostructure can comprise a second barrier layer containing InAsSbP and arranged between the substrate and the active layer. The heterostructure is formed from organometallic compounds by means of a vapor-phase epitaxy technique. The following compounds are used as epitaxial layer growth sources for the prior art heterostructure: trimethylindium TMIn (source of indium), trimethylstibine TMSb (source of stibium), hydride gases arsine $AsH_3$ (source of arsenic) and phosphine $PH_3$ (source of phosphorus). The hydride gases are diluted in hydrogen to 20% concentration. Diethylzinc DeZn is used for doping epitaxial layers with a p-type dopant (zinc).

The disadvantage of the prior art method of producing light-emitting diodes is the use of highly toxic hydride gases arsine and phosphine as sources of arsenic and phosphorus, respectively. Furthermore, reactions involving arsine and phosphine are accompanied by side reactions adversely affecting the composition and properties of grown structure.

Further, the prior art light-emitting diodes have radiation peaks in the limited wavelength range of 3.3 - 3.4 $\mu$m, which significantly limits the number of compounds that can be sensed using prior art light-emitting diodes. Furthermore, the barrier layer of prior art heterostructure does not allow for secure retention of primary charge carriers in the active area, which reduces efficiency of light-emitting diodes and photodiodes.

Therefore, despite the fact that various heterostructures for a mid-infrared spectral range and light-emitting diodes based thereon are known in the art, there is still a need for heterostructures in which the barrier layer provides secure retention of primary charge carriers in the active area and allows to increase radiative recombination ratio in the active area. Furthermore, the need exists for light-emitting diodes based on such heterostructures that can be produced for operation at any wavelength within the 2.6 - 4.7 $\mu$m range, as well as photodiodes for operation at any wavelength within the 2.0 - 4.7 $\mu$m range. Still furthermore, the need exists for a method, according to which such structures are produced by a vapor-phase epitaxy technique without using toxic hydride gases such as arsine and phosphine.

SUMMARY OF THE INVENTION

An object of the present invention is to provide a method of producing a heterostructure without use of toxic and hazardous gases (arsine and phosphine).

Another object of the present invention is to provide a reliable and effective heterostructure providing electron confinement in an active area.

Another object of the present invention is to provide a light-emitting diode based on the heterostructure.

Another object of the present invention is to provide a method of producing the light-emitting diode based on the heterostructure.

Another object of the present invention is to provide a photodiode based on the heterostructure.

Another object of the present invention is to provide a method of producing the photodiode based on the heterostructure.

According to the first aspect of the present invention, the object is achieved by a first embodiment of the method of producing a heterostructure, the method including: growing, by a vapor-phase epitaxy technique, a barrier layer containing InSbP on a substrate containing InAs; growing, by a vapor-phase epitaxy technique, an active layer containing InAsSbP on the barrier layer; wherein tert-butylarsine is used as a source of arsenic, and tert-butylphosphine is used as a source of phosphorus.

In the second embodiment of the method of producing heterostructures, the method incluyding growing, by a vapor-phase epitaxy technique, an active layer containing InAsSb on a substrate containing InAs; growing, by a vapor-phase epitaxy technique, a barrier layer containing InSbP on the active layer; tert-butylarsine is used as a source of arsenic, and tert-butylphosphine is used as a source of phosphorus.

According to the second aspect of the present invention, the object is achieved by that the heterostructure according to the first embodiment comprises a substrate containing InAs, a barrier layer which contains InSbP and which is arranged on the substrate, and an active layer which contains InAsSbP and which is arranged on the barrier layer.

In the second embodiment, the heterostructure comprises a substrate containing InAs, an active area which contains InAsSb and which is arranged on the substrate, and a barrier layer which contains InSbP and which is arranged on the active area.

Furthermore, according to the second embodiment of the heterostructure, the active area comprises a bulk layer containing InAsSb.

In another embodiment of the heterostructure, the active area comprises quantum wells containing InAs and InAsSb.

In another embodiment of the heterostructure, the active area comprises a strained superlattice containing GaInAs and InAsSb.

According to the third aspect of the present invention, the object is achieved by a light-emitting diode for producing radiation in a mid-infrared spectral range, the light-emitting diode comprising: at least one light-emitting diode (LED) chip which is formed on the basis of the first embodiment of the heterostructure and which comprises a first contact arranged on the substrate side and a second contact arranged on the active layer side.

In the second embodiment, a light-emitting diode for a mid-infrared spectral range comprises at least one light-emitting diode (LED) chip which is formed on the basis of the second embodiment of the heterostructure and which comprises a first contact arranged on the barrier layer side and a second contact arranged on the substrate side.

In one embodiment of the light-emitting diode, the first contact is continuous, and the second contact has a partially covered surface.

In one embodiment of the light-emitting diode, the second contact is round-shaped or ring-shaped.

In one embodiment of the light-emitting diode, the contacts comprise a four-layer Cr/Au/Ni/Au system.

In yet another embodiment, a light-emitting diode for a mid-infrared spectral range comprises at least one light-emitting diode (LED) chip which is formed on the basis of the first or the second embodiment of the heterostructure and which comprises at least two contacts arranged on the LED side opposite to the LED emitting side.

According to the fourth aspect of the present invention, the object is achieved by a method of producing the light-emitting diode of the third aspect, the method including: providing the heterostructure of the first or the second embodiment, forming two contacts on the opposite sides of the heterostructure, and splitting the heterostructure with contacts formed thereon to form light-emitting diode (LED) chips.

In another embodiment of the method of producing a light-emitting diode, the method including: providing the heterostructure of the first embodiment or the heterostructure of the second embodiment, forming at least two contacts on the substrate side or forming at least two contacts on the barrier layer side, the heterostructure with contacts formed thereon is split to form light-emitting diode (LED) chips.

According to the fifth aspect of the present invention, the object is achieved by a photodiode for a mid-infrared spectral range, the photodiode comprising: at least one photodiode chip which is formed on the basis of the second embodiment of the heterostructure and which comprises two contacts, wherein one of the contacts is arranged on the substrate side, and the other contact is arranged on the barrier layer side.

In one embodiment of the photodiode, one of the contacts has a partially covered surface, and the other contact is continuous.

In one embodiment of the photodiode, one of the contacts is ring-shaped.

In one embodiment of the photodiode, the contacts comprise a four-layer Cr/Au/Ni/Au system.

In yet another embodiment, a photodiode for a mid-infrared spectral range comprises at least one photodiode chip which is formed on the basis of the second embodiment of the heterostructure and which comprises at least two contacts arranged on a side of photodiode opposite to a radiation-receiving side of the photodiode.

According to the sixth aspect of the present invention, the object is achieved by a method of producing the photodiode of the fifth aspect, the method including: providing the heterostructure of the second embodiment; forming two contacts on the opposite sides of the heterostructure, and splitting the heterostructure with contacts formed thereon to form photodiode chips.

In another embodiment of the method of producing the photodiode of the fifth aspect, the method including: providing the heterostructure of the second embodiment, forming at least two contacts on the barrier layer side or forming at least two contacts on the substrate side, and splitting the heterostructure with contacts formed thereon to form photodiode chips.

TECHNICAL EFFECT

Introduction of a barrier layer containing InSbP into the heterostructure composition according to the present invention provides electron confinement at the heterointerface with the active area. As a result, the concentration of charge carriers and defects in the active area is reduced and the Shockley-Read nonradiative recombination ratio is reduced, thus increasing operating efficiency of light-emitting diodes and photodiodes.

Furthermore, use of tert-butylarsine $C_4H_9AsH_2$ as a source of arsenic instead of hydride gas $AsH_3$ and use of tert-butylphosphine $C_4H_9PH_2$ as a source of phosphorus instead of $PH_3$ allows reducing contamination of grown layers with impurities, to increase structural perfection of epitaxial structures and to increase safety and environmental friendliness of the heterostructure growth process.

Furthermore, in the first embodiment of the light-emitting diode of the present invention, high efficiency is achieved due to the fact that in said LED structure, the radiation is output through the n-InAsSbP active layer. The output of radiation from the LED structure volume avoiding material with p-type conductivity allows avoiding absorption of radiation by free holes that is significantly stronger than the absorption by free electrons. Furthermore, the disclosed LED structure provides a minimal active area temperature during a current flow due to the fact that a minimum-resistance contact system has been selected.

Furthermore, in the second embodiment of the light-emitting diode of the present invention, high efficiency is achieved due to the fact that in said LED structure, the radiation is output through the highly-doped n-InAs substrate. The Burstein-Moss effect leads to an increased Fermi level in the InAs substrate up to 100 meV. The increased Fermi level in the InAs substrate makes the substrate transparent for radiation as generated in the active area volume. Furthermore, the disclosed LED structure provides a minimal active area temperature during a current flow due to the fact that point contacts are formed on a narrow-band highly doped material (n-InAs), a contact system with minimum resistance is provided, the LED chips are mounted with the epitaxial side directed downwards, thus providing effective heat removal because the distance between the p-n junction and the metallic surface does not exceed several microns.

BRIEF DESCRIPTION OF THE DRAWINGS

Fig. 1 shows energy diagrams of prior art LED structures of two types (a and b);
Fig. 2 shows a scheme of the first embodiment of the heterostructure according to the present invention;
Fig. 3 shows a scheme of the second embodiment of the heterostructure according to the present invention;
Fig. 4 shows a scheme of the epitaxial apparatus for growing structures from organometallic compounds by a vapor-phase epitaxy technique;
Fig. 5 shows a diffraction rocking curve of the $InAs_{0.27}Sb_{0.23}P_{0.5}$ solid solution;
Fig. 6 shows a diffraction rocking curve of the $InSb_{0.32}P_{0.68}$ solid solution;
Fig. 7 shows a scheme of contact area arrangement for taking measurements.

The embodiments of the present invention are discussed below with reference to accompanying drawings. Said embodiments are provided by the way of example and are not meant to be limiting. The scope of the invention is defined and limited by the appended claims.

DETAILED DESCRIPTION OF THE INVENTION

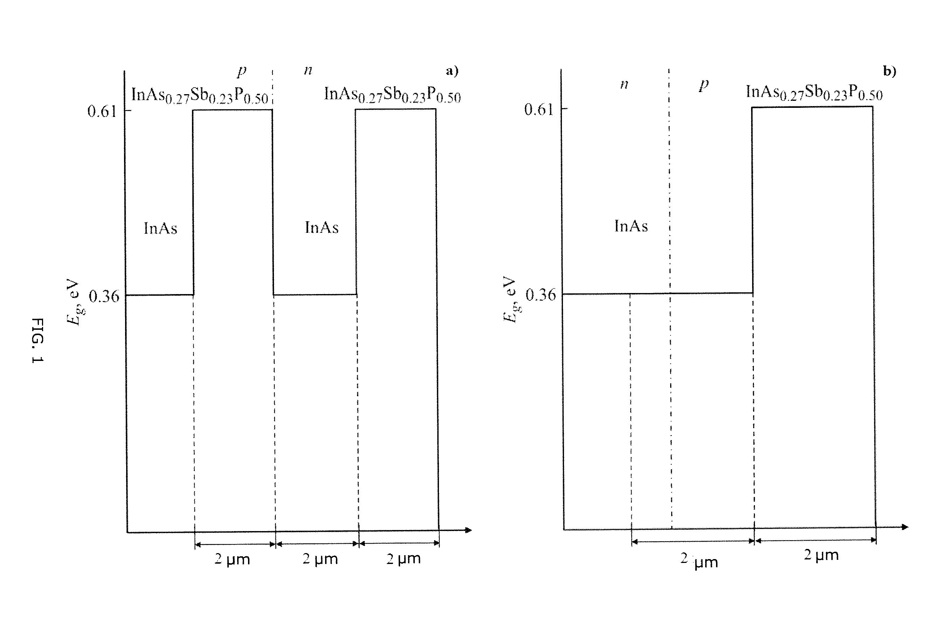

Fig. 1 shows energy diagrams of prior art LED structures. Fig. 1(a) shows a prior art structure of the first type grown on a p-type substrate containing InAs and doped with zinc. The epitaxial part of the structure comprises a barrier layer $InAs_{0.27}Sb_{0.23}P_{0.5}$ doped with zinc, a non-doped active area InAs and a non-doped barrier layer слоя $InAs_{0.27}Sb_{0.23}P_{0.5}$. Epitaxial layers have the following thickness values: active area InAs: 2 $\mu$m, lower barrier layer

InAsSbP: 1 $\mu$m, upper barrier layer InAsSbP: 2 $\mu$m. A continuous ohmic contact is formed on the substrate side, and a point contact with a diameter of 100 $\mu$m is formed on the epitaxial layer side.

Fig. 1(b) shows a prior art structure of the second type grown on an n-type substrate containing InAs and doped with sulfur. The epitaxial part of the structure comprises a deliberately non-doped layer InAs with 2 $\mu$m thickness and a zinc-doped barrier layer $InAs_{0.27}Sb_{0.23}P_{0.5}$ with 2 $\mu$m thickness. The p-n junction is arranged in the active area InAs at a distance of 0,5 $\mu$m from the interface between the substrate and the epitaxial part of the structure. A continuous contact is applied on the epitaxial layer side, and point contacts with diameters of 100 $\mu$m are formed on the substrate side. The LED chips are therefore mounted with the epitaxial side facing downwards.

The light-emitting diode operation can be represented as a sum of processes of non-primary charge carrier diffusion, recombination at the heterointerface between the active area and the barrier layers, radiative and nonradiative recombination in the active area volume, radiation self-absorption in the active area of the diode, and output of the generated radiation from the semiconductor volume. High diffusion length of charge carriers provides significant effect of interface recombination on the operation of the light-emitting diode. The radical interface recombination cannot be reduces by increasing active area thickness, as it leads to an increase in radiation self-absorption in the active area. The overall recombination rate in the active area volume of the diode can be expressed as:

$$R_{tot} = e(A_{SRH}n + B_{rad}n^2 + C_{Auger}n^3)d,$$

wherein

n is the concentration of charge carriers in the active area, e is the electron charge, and d is the active area thickness. The overall recombination includes the Shockley-Read nonradiative process ($A_{SRH}n$), the radiative recombination ($B_{rad}n^2$) and the nonradiative Auger recombination ($C_{Auger}n^3$). It follows from the above equation that the Shockley-Read nonradiative recombination proportional to n is prevalent at low injection levels. The nonradiative Auger recombination proportional to $n^3$ is prevalent at high injection levels. Light-emitting diodes based on InAs operate according to modes wherein the density of injected carriers is comparable to charge carrier concentration in deliberately non-doped material, and amounts to about $10^{16}$ cm$^{-3}$. The Shockley-Read recombination caused by contaminates and defects in the structure therefore constitutes an important barrier to increasing efficiency of light-emitting diodes, and must be minimized.

In order to improve structural perfection of epitaxial structures, to reduce the probability of Shockley-Read nonradiative processes and to increase quantum efficiency of radiative recombination of light-emitting diodes of the present invention, a heterostructure is disclosed, wherein the barrier layer contains InSbP.

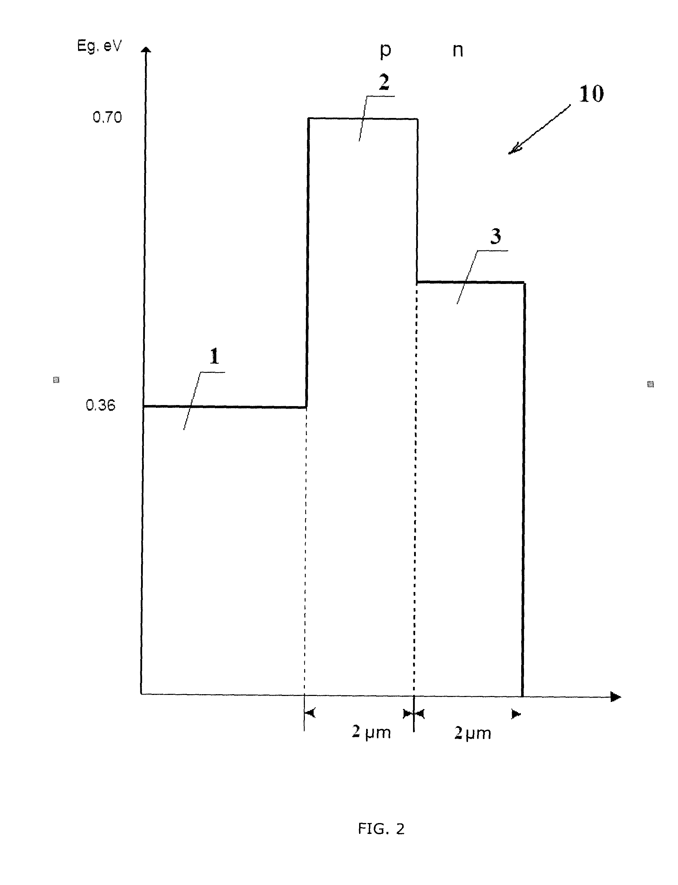

Fig. 2 shows a scheme of the first embodiment of the heterostructure according to the present invention. Heterostructure 10 comprises a substrate 1 containing InAs and doped with zinc with p-charge carrier concentration of about $2*10^{18}$ cm$^{-3}$, a barrier layer 2 arranged on the substrate 1, containing $InSb_{1-z}P_z$ and doped with zinc with p-charge carrier concentration up to about 1 - $3*10^{18}$ cm$^{-3}$, an active layer 3 arranged on the barrier layer 2, having thickness of about 2 $\mu$m, containing $InAs_{1-x-y}Sb_xP_y$ and deliberately non-doped with n-charge carrier concentration of about 2 - $4*10^{17}$ cm$^{-3}$. InP content in the barrier layer 2 is about 68%, and InSb content in the barrier layer 2 is about 32%. The radiation wavelength of the light-emitting diode and the isoperiodicity requirement between the layers of epitaxial structure and the substrate define the required InP and InSb content in the InAsSbP solid solution. Correlation of diffraction rocking curves of the samples and measurement data of elemental composition of $InAs_{1-x-y}Sb_xP_y$ solid solutions shows that the alignment of lattice parameters of $InAs_{1-x-y}Sb_xP_y$ layer and InAs substrate occurs in the event when the ratio between mole fractions of InP and InSb in the solid phase is y/x = 2.1. Mole fractions of InP and InSb in the active layer are adjusted depending on light-emitting diode wavelength, and for the wavelength of about 2.6 $\mu$m, the mole fractions are y = 25%, x = 12%, respectively. As radiation wavelength increases, the fraction of InP and InSb decreases. For the wavelength of about 3.0 $\mu$m, the mole fractions are y = 11%, x = 5%, respectively. In the utilized structures, the error ratio of lattice parameters of the barrier layer 2 containing InSbP and of the active layer 3 containing InAsSbP amounts to $\Delta a/a$ less than $2*10^{-4}$. The barrier layer 2 containing InSbP promotes a more secure retention of charge carriers within the volume of the active area of heterostructure 10, while also minimizing nonradiative processes in the active area, compared to the barrier layer InAsSbP in prior art heterostructures. The heterostructure 10 shown in Fig. 2 is used for producing light-emitting diodes operating in the wavelength range of 2.6 - 3.1 $\mu$m.

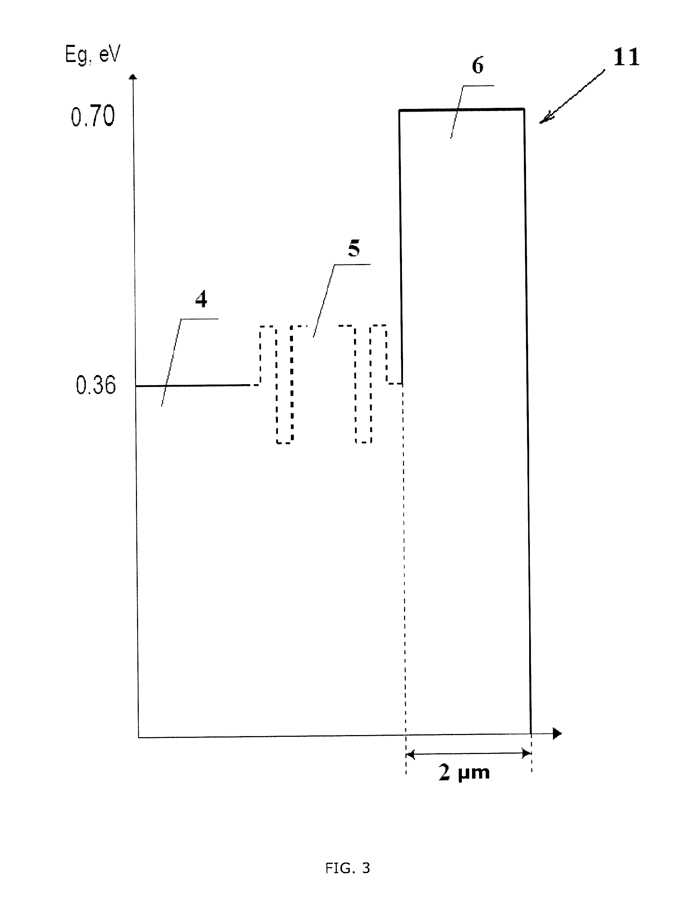

Fig. 3 shows a scheme of the second embodiment of the heterostructure according to the present invention. Heterostructure 11 comprises a substrate 4 containing InAs and doped with sulfur with n-charge carrier concentration of about $2*10^{18}$ cm$^{-3}$, a deliberately non-doped active area 5 arranged on the substrate 4 and having thickness of about 2 $\mu$m, and a barrier layer 6 arranged on the active area 5, containing InSbP and doped with zinc to a p-concentration of about 1 - $3*10^{18}$ cm$^{-3}$. InP content in the barrier layer 6 is about 68%, and InSb content in the barrier layer 6 is about 32%. In one embodiment of the heterostructure 11, the active area 5 comprises a bulk layer containing InAsSb with the mole fraction of InSb in the active area up to 15 %. In yet another embodiment of the heterostructure 11, the active area 5 comprises quantum wells InAs/InAsSb. The quantum well is formed by a thin flat layer of semiconductive material (generally with thickness of 1-10 nm), wherein the potential energy of an electron is lower than outside the well; therefore, electron movement is limited in one dimension. According to the laws of quantum mechanics, electron energy in such well is quantized, i.e. can only assume particular discrete values. In yet another embodiment of the heterostructure 11, the active area 5 comprises strained superlattices GaInAs/InAsSb. Thickness of the bulk layer InAsSb in the active area is about 2,5 $\mu$m. In the case of using alternating quantized layers InAs/InAsSb or GaInAs/InAsSb in the active area, the thickness of each layer is, for example, 10 nm, and the overall number of periods is about 108. Due to zinc diffusion into the epitaxial structure during InSbP layer growth, the p-n junction is located in the active area at a distance of 0.3 $\mu$m from the interface between the InAs substrate and the epitaxial part of the structure. The disclosed heterostructure 11 allows to increase quantum efficiency of radiative recombination by 20% compared to samples based on prior art voluminous heterostructure InAs/InAsSbP, and further allows to create photodiodes with high ampere-watt sensitivity values. Furthermore, the barrier layer 6 containing InSbP promotes a more secure retention of charge carriers within the volume of the active area 5 of heterostructure 11, while also minimizing nonradiative processes in the active area 5, compared to the barrier layer InAsSbP in prior art heterostructures. The use of quantum wells InAs/InAsSb and strained superlattices GaInAs/InAsSb alleviates the problem of epitaxial dislocation occurrences compared to voluminous structures. Quantized structures further allow to decrease the occurrence of nonradiative Auger processes. In order to produce a heterostructure operating at the 3.4 $\mu$m wavelength, an InAsSb bulk layer is formed with a mole fraction of InSb of about 0% in the active area. The 3.2 $\mu$m wavelength can be obtained by using a GaInAs/InAs superlattice. Further, the second embodiment of the heterostructure allows to obtain the same wavelength using different methods. For example, the wavelength of 4,4 $\mu$m can be obtained by an active area formed as a bulk layer InAsSb with mole fraction of InSb about 8,5%, or by an active area formed as quantum wells InAs/InAsSb (with well thickness of about 10 nm) with mole fraction of InSb about 11%. The heterostructure 11 shown in Fig. 3 according to the present invention is used for producing light-emitting diodes operating in the wavelength range of 3.1 - 4.7 $\mu$m and photodiodes operating in the wavelength range of 2.0 - 4.7 $\mu$m. Further, photodiodes based on the second embodiment of the heterostructure also operate at shorter wavelengths.

Furthermore, according to the present invention, width of forbidden gap Eg of the barrier layer 2, 6 containing InSbP is 0.7 eV, as shown in Fig. 2 and 3, respectively, and exceeds the width of forbidden gap of the barrier layer InAsSbP of the prior art heterostructure (0.61 eV) according to Fig. 1. Therefore, the electron confinement in the active area of the diode is improved.

The first or the second embodiment of the heterostructure can be selected according to the wavelength, at which the light-emitting diodes and photodiodes of the present invention should operate. The selection of the second embodiment of the heterostructure for producing light-emitting diodes operating in the spectral range of 3.1 - 4.7 $\mu$m is determined due to the following considerations. The wavelength of 3.1 $\mu$m is an approximate boundary for allowing radiation output through the substrate InAs. In the highly-doped substrate n-InAs, due to the Burstein-Moss effect, the increase in Fermi level can reach 100 meV, which makes the substrate transparent for radiation with the wavelength of at least 3.1 $\mu$m. The substrate transparency allows to apply a continuous cpmtacy on the grown layers side during photolithography of epitaxial structures and to mount light-emitting diodes with epitaxial side facing downwards. Said mounting method significantly improves heat removal, as the p-n junction is arranged at a distance of several micron from the holder, i.e., providing minimal local temperature in the active area during current flow. It is not possible to select an active area composition that would be isoperiodic to InAs substrates for light-emitting diodes with wavelengths over 3.3 - 3.4 $\mu$m. Bulk layers non-isoperiodic to the InAs substrate, strain-alleviating quantum wells or strain-compensating superlattices can be used in the active area.

Furthermore, heterostructures of the present invention are not limited to the use of aforementioned compounds as doping additions; any other doping additions providing the required charge carrier concentration in the layer can also be used.

The heterostructure of the present invention is produced by a method utilizing vapor-phase epitaxy technique from organometallic compounds. Furthermore, those skilled in the art can manufacture the disclosed embodiments of heterostructures using any equipment for a vapor-phase epitaxy technique. It should be noted that the method is not limited to a vapor-phase epitaxy technique, and the heterostructures can also be produced by using methods of molecular-beam epitaxy, liquid-phase epitaxy or by using any other methods suitable for producing heterostructures with the structure according to the present invention. It also should be noted that, according to the present invention, the use of the vapor-phase epitaxy technique from organometallic compounds is preferable.

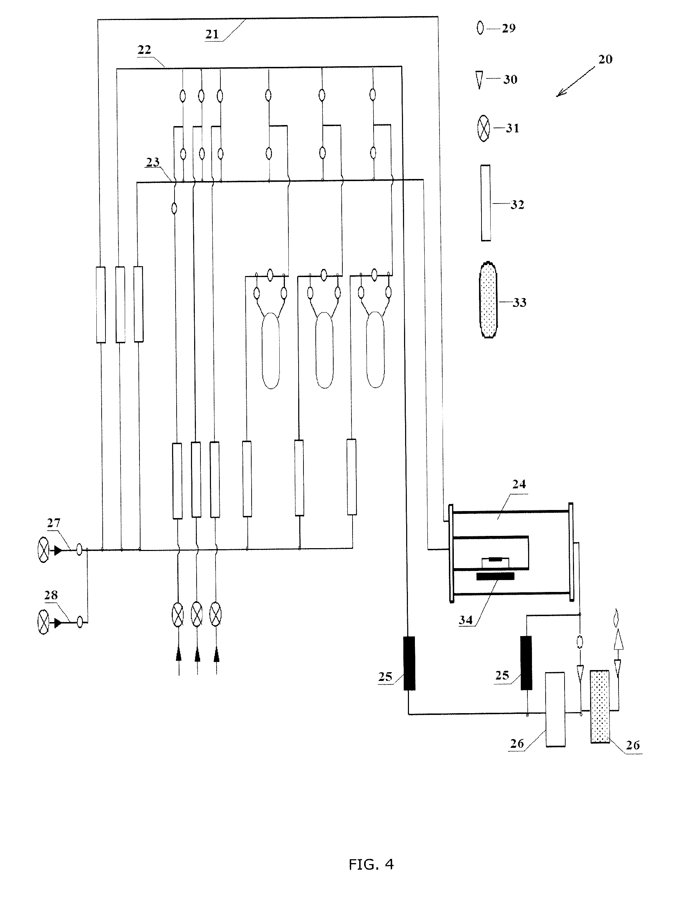

Fig. 4 shows a scheme of the epitaxial apparatus 20 for growing structures from organometallic compounds by a vapor-phase epitaxy technique (OMC VPE). The apparatus 20 comprises a gas flow control system (not shown), a purging like 21, a dump line 22, a primary line 23, a reaction chamber 24, a heater 34 for heating the substrate, and a toxic waste disposal system comprising afterburners 25 and filters 26. Fig. 4 shows a hydrogen supply line 27 and a nitrogen supply line 28. Further, Fig. 4 shows vessels 33 with organometallic compounds, gas regulators 32, valves 31, reservoirs 30 and shutters 29.

The gas system necessary for preparing and supplying a vapor-gas mixture into the reaction chamber 24 consists of vessels 33 with organometallic compounds, thermostatic ovens (not shown) for maintaining organometallic compounds at a set temperature, gas regulators 32, shutters 29 and valves 31 for highly purified media.

Gas regulators 32 are installed in primary hydrogen supply lines 27 and in lines leading to feeders (vessels 33 with organometallic compounds). Gas regulators 32 are formed as a system of automatic gas flow rate control with an electric output signal with voltage of 0 to 10 V proportional to the gas flow rate. Feeders also constitute a part of the gas system. The operational principle of the feeder is based on hydrogen forming a complex vapor-gas mixture when passing through a layer of liquid or powder. The mixture composition is controlled by the flow of hydrogen passing therethrough and by the temperature of the organometallic compound. The organometallic components are mixed in the reaction chamber 24 at atmospheric pressure or at slightly lowered pressure (about 150 mmHg).

Organometallic compounds (OMC) are a wide class of substances containing metal-carbon bonds and coordination compounds of metals with organic molecules.

Organometallic compounds relevant for growing semiconductor film are usually liquid at room temperature, although some compounds remain solid at room temperature and even at higher temperatures. Organometallic compounds usually have a relatively high vapor pressure, and can be easily supplied to the reactor 24 by passing a carrier gas, e.g. nitrogen, hydrogen, argon or helium, through the liquid or over the solid compound functioning as the source.

According to OMC VPE technology, crystallization on the substrate surface occurs as a result of thermal decomposition and interaction between components in the vapor phase. The monocrystalline substrate is placed on the heated holder. Gas mixture adjacent to the substrate surface is heated to high temperatures, whereas the walls of the reaction chamber 24 remain relatively cool, which leads to condensation of the semiconductor film on the crystalline substrate with low reagent loss on the surface of reaction chamber 24. Parameters of the gas mixture can be controlled using an electronic system controlling flow rate from each source.

Growth of layers of the heterostructure of the present invention is the result of decomposition of individual molecules containing elements of the third and fifth periods. The gas flow dynamics in the reactor at atmospheric or near-atmospheric pressure leads to formation of a boundary layer near the static surface of the substrate. Reagent decomposition occurs in the hot boundary layer, through which the molecules pass towards the substrate, or on the surface of the substrate itself. Boundary layer thickness increases in the direction of the flow. The incoming gas mixture contains reagents at higher concentrations than those present in case of equilibrium with the substrate at growth temperature, i.e., the gas is strongly oversaturated, but equilibrium is formed at the interface between the gas and the solid body. Reagents diffusing through the boundary layer decompose, releasing atoms of substances required for layer growth. When diffusion rate through the boundary layer exceeds reagent decomposition rate, the kinetics of surface processes notably affects film growth.

Doping of the growing epitaxial layer in OMC VPE is performed by introducing the corresponding reagent to the gas flow. The reagent is diffused through the boundary layer similarly to the primary reagents forming the layer. The introduction of additions to the crystal lattice can be defined by surface reactions such as adsorption-desorption or surface catalysis, or by reagent thermochemistry. Zinc and magnesium are generally used for doping compounds $A^3B^5$ with p-type additions, and organometallic reagents based on tellurium, stannum or selenium are generally used for doping with n-type additions. Hydrides (e.g. $H_2Se$, $SiH_4$) can also be used for doping epitaxial layers.

The OMC VPE method can provide structures with uniform thickness on large-area substrates. The method can be used for synthesizing film with thickness of several atomic layers.

The method of forming heterostructures of the present invention utilizes the following parent materials: trimethylindium (TMIn) as the source of indium, trimethylstibine (TMSb) as the source of stibium, trimethylgallium (TMGa) as the source of gallium, tert-butylarsine ($C_4H_9AsH_2$) as the source of arsenic, tert-butylphosphine ($C_4H_9PH_2$) as the source of phosphorus, and diethylzinc (DeZn) as the source of doping addition (zinc).

In prior art method of forming structures, hydride gases are used, such as arsine ($AsH_3$) as the source of arsenic and phosphine ($PH_3$) as the source of phosphorus. Arsine ($AsH_3$) and phosphine ($PH_3$) are the most commonly used sources of arsenic and phosphorus in OMC VPE technology, despite their high toxicity and tendency to enter side reactions. Certain difficulties when working with gas tanks containing pressurized toxic gas are thus inevitable. Organometallic compounds are substantially less dangerous in operation, and can be arranged in stainless stell barrels at atmospheric pressure.

The tendency of hydrides to enter side reactions mentioned above causes significant difficulties in arranging reproducible production of layers of In-containing compounds. Growing an InAs reaction in a gas mixture containing TMIn and $AsH_3$ leads to the formation of an unstable compound $InR_3 \cdot PH_3$, wherein R is an alkyl, said compound spontaneously decomposing with the formation of involatile polymer $(InRPH)_n$ and $CH_4$ gas. The polymer precipitates at the approach to the growth zone in the reactor, causing loss in growth efficiency and loss in uniformity of the epitaxial layer. Furthermore, reactor inlet walls operate as a catalyzer of adduct decomposition, and therefore, decomposition rate is sensitive to small changes in surface texture. As a result, the process can perform differently in different systems, or even in one system at different times. InAs grown in such manner is characterized by low and unstable quality with respect to electrical properties and morphology.

In order to improve structural perfection of epitaxial layers in accordance with the method of producing the heterostructure of the present embodiment, replacement of hydride gases arsine and phosphine with alternative sources of arsenic and phosphorus is proposed. Various organometallic compounds, such as trimethylarsine (TMAs), tert-butylarsine (TBAs), phenylarsine (PhAs), monoethylarsine (MEAs) and tert-butylphosphine (TBP) can be used to replace arsine and phosphine in OMC VPE.

Organometallic compounds are also sources of contaminants that can integrate into the epitaxial layer and affect electrical properties, concentration and mobility of charge carriers. The effect of undesirable contaminants is reduced by improving organometallic compound production and purification technology. Carbon is a natural contaminant as part of products of incomplete decomposition of In-containing organometallic compounds (In-CH$_x$ radicals).

The level of carbon contamination of the epitaxial layer is defined by the ratio of radicals AsH$_x$ and As reaching the surface. As-H$_2$ and As-H radicals are products of arsenic source decomposition and decrease carbon contamination of the epitaxial layer due to the fact that said radicals bond with In-CH$_x$ compounds (products of incomplete decomposition of In-containing OMCs), not allowing them to integrate into the layer being grown.

The use of tret-butylarsine C$_4$H$_9$AsH$_2$ instead of hydride gas AsH$_3$ as the source of As, and the use of tert-butylphosphine C$_4$H$_9$PH$_2$ instead of PH$_3$ as the source of P allows to decrease integration of carbon radicals into the layer being grown. Despite the fact that tert-butylarsine and tert-butylphosphine are organometallic compounds, and therefore introduce additional carbon into the vapor phase, reactions above the substrate lead to mutual neutralization of carbon radicals and to a decrease in epitaxial layer contamination. As a result of using the method of forming heterostructures of the present invention, the concentration of charge carriers and defects in the active area is reduced and the Shockley-Read nonradiative recombination ratio is reduced, thus increasing operating efficiency of light-emitting diodes and photodiodes.

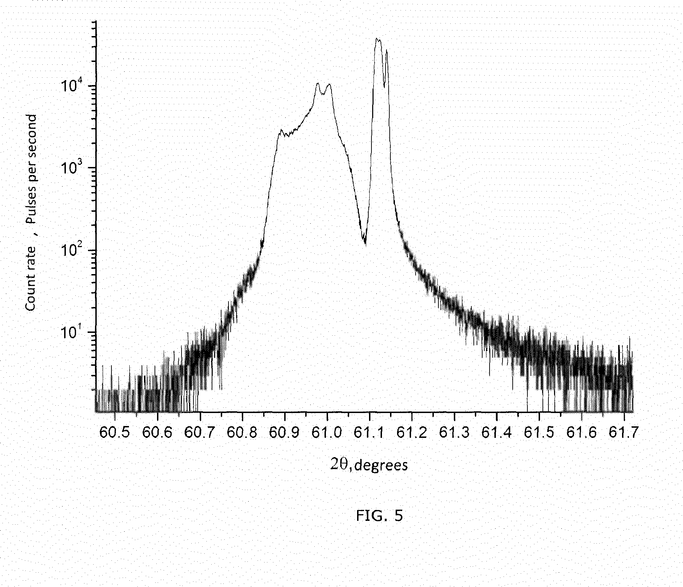

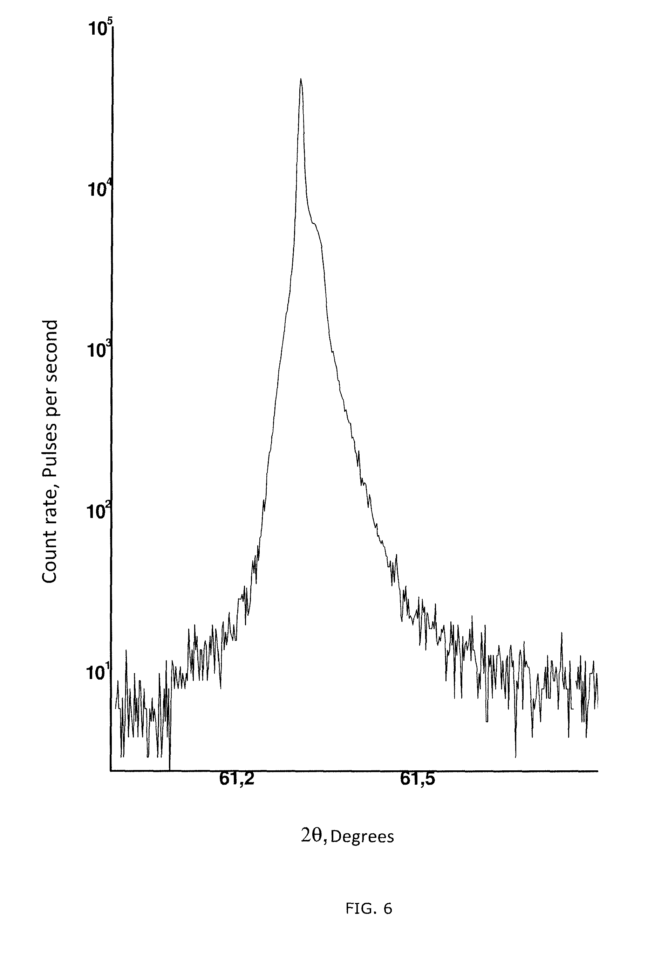

Figs. 5 and 6 respectively show diffraction rocking curves of prior art InAs$_{0.27}$Sb$_{0.23}$P$_{0.5}$ solid solution grown using hydride sources on InAs substrate (100), and the InSb$_{0.32}$P$_{0.68}$ barrier layer of the present invention also grown on InAs substrate (100), but using tert-butylarsine and tert-butylphosphine. Several peaks on the diffraction rocking curve of examples shown in Fig. 5 and grown using hydrides is probably attributed to decomposition of InAsSbP solid solutions into individual phases. Fig. 6 shows a diffraction rocking curve with a single narrow and prominent peak. Therefore, the improvement in structural perfection of epitaxial layers in case of using organometallic sources of As and P (tert-butylarsine and tert-butylphosphine) is evident. The improvement in structural perfection of epitaxial structures lowers the rate of occurrence of Shockley-Read nonradiative processes and increases quantum efficiency of radiative recombination of light-emitting diodes.

The method of forming heterostructures according to the present invention by a vapor-phase epitaxy technique includes the following preliminary steps: loading the substrate ready for epitaxy (epi-ready) into the reaction chamber 24, purging the reaction chamber 24 with neutral gas (nitrogen) over 20 minutes, supplying hydrogen into the reaction chamber 24, exhaustion of the reaction chamber 24 (said procedure is carried out in order to ensure that the reaction chamber 24 is hermetically sealed), turning off the pump and supplying hydrogen to the reaction chamber 24, measuring the hydrogen dew point over 2 minutes (said procedure is carried out in order to test purity of the hydrogen carrier gas and to ensure that that couplings of the gas distribution system are hermetically sealed), heating the substrate to 350 °C and removal of oxide film from the substrate surface over 5 minutes, supplying tert-butylarsine into the reactor, heating the substrate to 600 °C under the flow of tert-butylarsine and annealing for 5 minutes (over the course of said step, the substrate surface is additionally cleaned), and cooling the substrate to the temperature of epitaxial structure growth (530 °C).

In order to grow the first embodiment of the heterostructure of the present invention on substrate 1 containing InAs, a barrier layer 2 containing InSbP is grown. In order to grow the barrier layer 2, trimethylindium, trimethylstibine, tert-buthylphosphine and diethylzinc are supplied to the reaction chamber 24 by means of a carrier gas. When the barrier layer 2 thickness reaches about 1 - 2 μm, the gas supply is stopped. The reaction chamber 24 is purged with hydrogen. In order to grow an active layer 3 containing InAsSbP on the barrier layer 2 , trimethylindium, tert-buthylarsine, trimethylstibine, and tert-buthylphosphine are supplied to the reaction chamber 24 by means of a carrier gas. When the active layer 3 thickness reaches 2 μm, the gas supply is stopped with the exception of tert-buthylarsine and tert-buthylphosphine. The grown structure is cooled to 400 °C under the flow of tert-buthylarsine and tert-buthylphosphine. Upon reaching 400 °C, the supply of tert-buthylarsine and tert-buthylphosphine is stopped, and further cooling of the grown heterostructure to room temperature is carried out under the flow of hydrogen. The reaction chamber 24 is unloaded after purging with neutral gas, e.g., nitrogen, over 20 minutes.

In order to grow the second embodiment of the heterostructure of the present invention on substrate 4 containing InAs and doped with sulfur, an active area 5 is grown. In one embodiment, the active area 5 is a bulk active layer containing InAsSb. In order to grow said active layer, trimethylindium, tert-buthylarsene and trimethylstibine are supplied to the reaction chamber 24 by means of a carrier gas.

In yet another embodiment, the active area 5 comprises quantum wells InAs/InAsSb. In order to grow layers forming said quantum wells, trimethylindium and tert-buthylarsene (with discrete supply of trimethylstibine) are supplied to the reaction chamber 24 by means of a carrier gas. Trimethylstibine is supplied for 15 seconds, and then the supply is stopped for 30 seconds.

In yet another embodiment, the active area 5 comprises a strained superlattice GaInAs/InAsSb. In order to grow said superlattice, trimethylindium and tert-buthylarsene (with alternating supply of trimethylgallium and trimethylstibine) are supplied to the reaction chamber 24 by means of a carrier gas. Trimethylgallium is supplied for 30 seconds, then the supply is stopped, and simultaneously with stopping the supply of trimethylgallium, trimethylstibine is supplied for 15 seconds.

When the active area 5 thickness reaches about 1 - 2 $\mu$m, the gas supply is stopped with the exception of tert-buthylarsine. The reaction chamber 24 is purged with hydrogen. In order to grow a barrier layer 6 containing InSbP on the active area 5, trimethylindium, trimethylstibine, tert-buthylphosphine and diethylzinc are supplied to the reaction chamber 24 by means of a carrier gas. When the barrier layer 6 thickness reaches 2 $\mu$m, the gas supply is stopped with the exception of tert-buthylarsine and tert-buthylphosphine. The grown structure is cooled to 400 °C under the flow of tert-buthylarsine and tert-buthylphosphine. Upon reaching 400 °C, the supply of tert-buthylarsine and tert-buthylphosphine is stopped, and further cooling of the grown structure to room temperature is carried out under the flow of hydrogen. The reaction chamber 24 is unloaded after purging with neutral gas (nitrogen) over 20 minutes.

The gas supply intervals, and subsequently, the growth time required to obtain a layer of specific thickness can be determined empirically. In case when the vapor-phase epitaxy equipment allows to control layer thickness in real time, and therefore to control growth time by any known means, the empirically acquired time value can be recorded as preliminary value.

In order to form a LED chip or a photodiode chip, post-growth processing of heterostructures is performed, said process including photolitographic processes and processes of forming ohmic contacts.

Forming ohmic contacts for the epitaxial structure is part of the technological process of producing a semiconductor device, e.g. a light-emitting diode or a photodiode. Ohmic contacts provide electrical connection between the diode and the external circuit. The contact between metal and semiconductor is ohmic if it is non-rectifying, i.e., the contact resistance is constant upon change in current direction, and if it has a linear voltage-current characteristic, i.e., the contact resistance does not depend on current flow value. Ohmic contacts must meet the following requirements. The contact must have low resistance in directions perpendicular and parallel to the plane of p-n junction; it must not inject non-primary charge carriers; and it must not penetrate the semiconductor deeply. The material used to manufacture the contact must form a stable physical and chemical system with the semiconductor; it must have high thermal conductivity; it must be neutral with respect to the semiconductor or must comprise an addition of the same type as the additions contained in the semiconductor (a donor for the electron semiconductor and an acceptor for the hole semiconductor); and it must provide high mechanical strength to the contact. Meeting the above requirements defines electrical properties of the devices and operational stability thereof in the wide range of operational conditions.

It should be noted that it is virtually impossible to manufacture a contact meeting all requirements set hereinabove. The reason for that lies in innate contradictions of the requirements: the contact between metal and semiconductor must be secure, but metal should not penetrate deeply into the epitaxial structure; the contact material must be neutral, and at the same time must be configured to reduce the oxide film of the semiconductor, as without said reduction, a satisfactory contact resistance cannot be achieved.

In order to produce high-quality contacts, multilayer systems can be advantageously used. A possible example of such system is the Cr (80 A) - Au (300 Å) - Ni (500 A) - Au (1000 A) contact that can be formed on heterostructures of the present invention. The first layer of chrome contacting the semiconductor provides low penetration depth of the contact into the epitaxial structure, reduces oxide films and provides good adhesion with the following gold layer applied thereon. Said chrome and gold layers form the main part of the contact system. As a chemically neutral metal with high conductivity, gold is used for forming the final upper conductive layer. The use of nickel film is necessary in order to prevent interaction between the contact layer and the conductive layer and to reduce diffusion of gold into the structure.

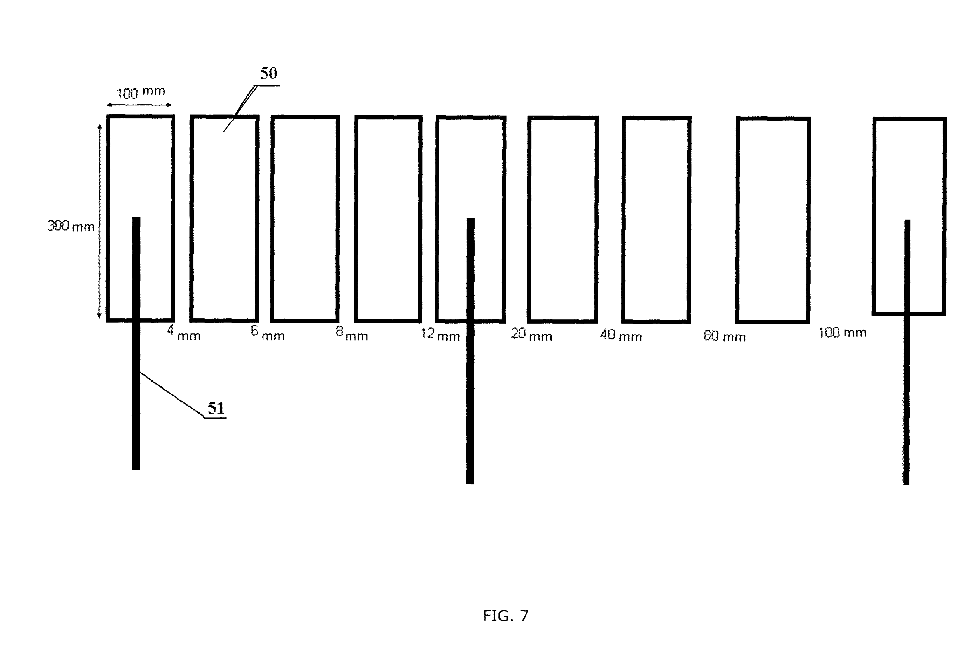

Ohmic contacts must have low resistance in order to reduce heat released upon passing electrical current therethrough. Various contact systems were studied with regards to the following materials: deliberately non-doped epitaxial layers n-InAs$_{32}$ with electron concentration of about $2*10^{16}$ cm$^{-3}$, n-InAs$_{0.53}$Sb$_{0.15}$P$_{0.32}$ with electron concentration of about $1.3*10^{17}$ cm$^{-3}$, p-InAs substrates with hole concentration of about $5*10^{18}$ cm$^{-3}$, and zinc-doped epitaxial layers p-InAs$_{0.53}$Sb$_{0.15}$P$_{0.32}$ with hole concentration of about $2*10^{18}$ cm$^{-3}$. As shown in Fig. 7, contact pads 50 sized 300*100 $\mu$m2, are produced for the selected materials and arranged sequentially with an interval of 4 to 100 mm. Driving elements 51 are welded to various contact pads 50 by means of ball bonding. Furthermore, the contacts are subjected to a pull-test. The contact system resistance was measured depending on the distance between contacts. A straight line passed through empirical points separated the value equal to doubled resistance of the contact pad on the vertical axis. The depth resistance of semiconductors selected for measurements was found to be negligible in comparison to contact resistance. Results of the contact system firing study are shown in Tables 1-4. Table 1 lists resistance of contacts coupled to p-InAs substrate (100) with hole concentration of about $5*10^{18}$ cm$^{-3}$. Table 2 lists resistance of contacts coupled to p-InAs$_{0.53}$Sb$_{0.15}$P$_{0.32}$ layer with hole concentration of about $2*10^{18}$ cm$^{-3}$. Table 3 lists resistance of contacts coupled to n-InAs epitaxial layer with electron concentration in the layer of about $1*10^{16}$ cm$^{-3}$. Table 4 lists resistance of contacts coupled to n-InAs$_{0.53}$Sb$_{0.15}$P$_{0.32}$ epitaxial ayer with electron concentration of about $1.3*10^{17}$ cm$^{-3}$.

Table 1

| Contact systems | Resistance, ohm | | | | |
|---|---|---|---|---|---|
| | Firing temperature, °C | | | | |
| | No firing | 250 | 300 | 350 | 400 |
| Cr-AuZn(25%)-Ni-Au | 0.3 | 0.3 | 0.3 | 0.3 | 0.4 |
| Cr-AuZn(5%)-Ni-Au | 5 | 0.4 | 0.7 | 0.4 | |
| AuZn (5%) | 0.7 | 0.7 | | | |

Table 2

| Contact systems | Resistance, ohm | | | | |
|---|---|---|---|---|---|
| | Firing temperature, °C | | | | |
| | No firing | 250 | 300 | 350 | 400 |
| Cr-AuZn(25%)-Ni-Au | 1.1 | 0.9 | 0.4 | 0.3 | 0.25 |
| Cr-AuZn(5%)-Ni-Au | 1.2 | 0.18 | 0.22 | 0.18 | |

Table 3

| Contact systems | Resistance, ohm | | | | |
|---|---|---|---|---|---|
| | Firing temperature, °C | | | | |
| | No firing | 250 | 300 | 350 | 400 |
| Cr-Au-Ni-Au | 23 | 0.5 | 0.4 | 0.3 | 0.4 |
| AuGe(12%)-Ni | 3.5 | 0.4 | 0.7 | 0.4 | |
| AuGe(1%)-Ni-Au | 3.5 | 3.2 | 1.6 | 2.5 | |
| AuTe(5%) | 3.5 | 4.5 | 3.5 | 3.2 | |
| AuTe-Ni-Au | 1.4 | 1 | 0.7 | 0.7 | |

Table 4

| Contact system | Resistance, ohm | |
|---|---|---|
| | Firing temperature, °C | |
| | No firing | 250 |
| Cr-Au-Ni-Au | 3.5 | 9 |

The analysis of measurement results indicates high quality of contacts coupled to highly-doped materials p-InAs and p-InAsSbP. Out of the studied materials, the minimal contact resistance with deliberately non-doped layer of indium arsenide (electron concentration about $2*10^{16}$ cm$^{-3}$) is provided by the contact system Cr-Au-Ni-Au. The resistance value shown (calculated as contact resistance by area thereof) is about $1*10^{-4}$ohm$*$cm$^2$ in the optimal firing mode.

The process of producing a LED chip or a photodiode chip based on the epitaxial structure with Cr-Au-Ni-Au contacts includes the following steps. The heterostructure is processed in acetone, degreased in tetrachloromethane and isopropyl alcohol, and then fired at 130 °C for 30 minutes.

Then photolitography is performed in order to form the first contact. Despite the fact that in this embodiment, the first contact is round-shaped or ring-shaped, the first contact can also be formed by a frame having a rectangular, ovoid or any other shapes; it can also be formed in the shape of dots, crosses or any continuous geometrical shapes without departing from the scope of the present invention. Photolitography includes the following steps: applying a photoresist, applying a "contacts" pattern, exposure, development and hardening at 100 °C for 1 hour. Then, prior to contact coating, the surface is cleaned, e.g. by processing in plasma. The Cr (80 A) - Au (300 A) - Ni (500 A) - Au (1000 A) contact is then coated on (thickness of each layer indicated in parentheses). After coating, the protective mask is removed in acetone. The heterostructure is then wiped in acetone, degreased in tetrachloromethane and isopropyl alcohol, and fired at 130 °C for 30 minutes.

Then galvanic photolitography is performed. Photolitography includes the following steps: applying a photoresist applying a "contacts" pattern, exposure, development and hardening at 100 °C for 1 hour. The opposide side and ends of the sample are closed with chemically stable varnish. The gold-galvanic strengthening of the contacts is performed. The heterostructure is then wiped in acetone, degreased in tetrachloromethane and isopropyl alcohol, and fired at 130 °C for 30 minutes.

Then photolitography is performed in order to form the separating net. Photolitography includes the following steps: applying a photoresist, applying a "separating net" pattern, exposure, development and hardening at 100 °C for 1 hour. The separating net is etched in the $HBr:H_2O_2$ anisotropic etchant. Furthermore, etching can be performed using dry etching methods, e.g. in plasma.

Then the face side is closed with a photoresist, and the structure is glued with the face side to glass by means of picein.

Further, the structure is thinned to thickness of 200 $\mu$m by abrading the substrate, and then the structure is processed in the $HCl:HNO_3:H_2O$ etch. Then the structure is washed to remove picein, and the photoresist is removed. The back surface is processed in plasma.

The Cr (80 A) - Au (300 A) - Ni (500 A) - Au (1000 A) continuous second contact is then coated on.

During the assembly process, the LED chip or photodiode chip is placed within a housing. The assembly process can be carried out using any known technology.

In LED chips, the selection of a side to apply the continuous contact and the point contact, and thus the choice of mounting method is made based on the following criteria: the substrate must be transparent to radiation generated in the volume of the active diode area, and the radiation output must be performed through a material with n-type conductivity, as absorption at free charge carriers in semiconductors with p-type conductivity is tens of times higher.

Considering the above criteria, in light-emitting diodes based on the first embodiment of the heterostructure, the continuous contact is applied on the substrate side, and point contacts are formed on the epitaxial layers side. The LED chips are mounted with the substrate facing downwards. Radiation is output through epitaxial layers.

In light-emitting diodes based on the second embodiment of the heterostructure, the continuous contact is applied on the epitaxial layers side, and point contacts are formed on the substrate side. The LED chips are mounted with the epitaxial side facing downwards. Radiation is output through the substrate.

Photodiodes are produced based on the second embodiment of heterostructures. The photosensitivity boundary of the diode from the long wavelength side $\lambda_{\kappa p}$ is defined by width of the forbidden gap Eg of the active area material. The short wavelength sensitivity boundary $\lambda_{\kappa op}$ depends on the width of the forbidden gap Eg of the "wideband window", through which light enters active area of the diode. Said "wideband window" can be formed by p-InSbP material or by the n-InAs substrate. The side through which radiation enters is determined by the required short wavelength sensitivity boundary. When the light enters from the n-InAs substrate side, $\lambda_{\kappa op}$ is about 3 $\mu$m and the diodes are mounted with the epitaxial side facing downwards. When the diodes are mounted with the epitaxial side facing upwards, the light passes through the wideband layer p-InSbP, and $\lambda_{\kappa op}$ is about 2 $\mu$m.

Furthermore, LED chips or photodiode chips based on the heterostructure of the present invention can be produced using any known methods or using any other known materials. For example, a light-emitting diode or photodiode with contacts for flip-chip mounting can be produced on the basis of the heterostructure of the present invention. In the case of producing a diode with contacts for flip-chip mounting, the contact coupled to the epitaxial side and the contact coupled to the substrate are placed on the bottom side, so that the upper surface of the heterostructure remains free. Producing the diode according to the present invention can be performed by using any methods suitable for a flip-chip technology.

Furthermore, the method of producing a light-emitting diode or a photodiode can include other photolithographic processes for forming elements of the light-emitting diode or photodiode, e.g. for forming a mesa.

The LED chip can have, for example, a square shape with dimensions of about 350*350 $\mu$m$^2$ with a point contact having a diameter of about 100 $\mu$m or an ring-shaped contact having a diameter of about 250 $\mu$m. The photodiode chip can be, for example, a square shape with dimensions of about 700*700 $\mu$m$^2$ with an ring-shaped contact having a diameter of about 500 $\mu$m.

Light-emitting diodes and photodiodes of the present invention operate at room temperature. Furthermore, when it is required to stabilize a certain temperature lower or higher than room temperature, diodes can comprise at least one Peltier element.

The light-emitting diode produced according to the present invention is operated as follows.

In the first embodiment of the heterostructure, upon application of forward voltage (positive to the substrate, negative to the active layer), the current flows through the heterostructure. Electrons are injected into the active area. High potential barrier from the side of the InSbP barrier layer limits the electron outflow from the active area. Holes from the p-type barrier layer are injected into the active area. Electrons and holes confined to the active area effectively recombinate, thus forming infrared radiation with a wavelength corresponding to the width of the forbidden gap of the active area. The radiation passes through the active layer with minimal losses and exits the light-emitting diode from the active layer side. Light-emitting diodes based on the first embodiment of the heterostructure emit at a wavelength in the range of 2.6 - 3.1 μm.

In the second embodiment of the heterostructure, upon application of forward voltage (positive to the barrier layer of the heterostructure, negative to the n-type substrate), the current flows through the heterostructure. Electrons are injected from the substrate into the active area. High potential barrier from the side of the InSbP barrier layer limits the electron outflow from the active area. Holes from the p-type barrier layer are injected into the active area. Electrons and holes confined to the active area effectively recombinate, thus forming infrared radiation with a wavelength corresponding to the width of the forbidden gap of the active area. The radiation passes through the substrate with minimal losses due to the fact that the substrate material does not absorb radiation in the range of 3.1 - 4.7 μm, and exits the light-emitting diode from the substrate side.

The photodiode produced according to the present invention is operated as follows.

When the photodiode is irradiated with a light flux through the n-InAs substrate or the p-InSbP layer, pairs of electric charges (free electrons and holes) are generated in the active layer InAsSb. The active layer of the photodiode comprises a depletion region of the semiconductor, which forms an integrated electric field and wherein the electron/hole pairs excited by the light are separated. Non-primary charge carriers (holes in the n-area) are pulled by the transition field and moved to the p-area of the semiconductor, where said holes constitute primary carriers. The newly formed primary charge carriers increase concentration of electrons in the n-area and lower resistance of the depletion region. Due to the movement of excess non-primary carriers formed by the light flux, a photoelectric current passing through the diode is formed. Electron/hole pairs generated in the wideband area (in the n-InAs substrate or in the p-InSbP layer) are also separated by the electric field and contribute to the photoelectric current. The long wavelength boundary of the photodiode is defined by the width of forbidden gap of the active layer of the photodiode. The short wavelength response boundary is defined by the width of the forbidden gap and by thickness of the material through which the light enters the active layer (in this case, it is defined by the width of the forbidden gap and by thickness of the n-InAs substrate or the p-InSbP layer).

The use of a "wideband window" (n-InAs substrate or p-InSbP layer) further allows to increase quantum efficiency in operation of the photodiode due to reduction in surface recombination.

It should be noted that the embodiments of the invention disclosed in the foregoing description are purely exemplary and not meant to be construed as limiting the scope of the invention. The spirit and scope of the present invention are defined solely in the following claims.

**Claims**

1. A method of producing a heterostructure, the method including:

    growning, by a vapor-phase epitaxy technique, a barrier layer containing InSbP on a substrate containing InAs,
    growning, by a vapor-phase epitaxy technique, an active layer containing InAsSbP on the barrier layer,
    wherein tert-butylarsine is used as a source of arsenic, and tert-butylphosphine is used as a source of phosphorus.

2. A heterostructure, comprising:

    a substrate containing InAs,
    a barrier layer which contains InSbP and which is arranged on the substrate,
    an active layer which contains InAsSbP and which is arranged on the barrier layer.

3. A method of producing a heterostructure, the method including:

    growing, by a vapor-phase epitaxy technique, an active layer containing InAsSb on a substrate containing InAs,

growing, by a vapor-phase epitaxy technique, a barrier layer containing InSbP on the active layer, wherein tert-butylarsine is used as a source of arsenic, and tert-butylphosphine is used as a source of phosphorus.

4. A heterostructure, comprising:

a substrate containing InAs,
an active area which contains InAsSb and which is arranged on the substrate,
a barrier layer which contains InSbP and which is arranged on the active area.

5. The heterostructure according to claim 4, wherein the active area comprises a bulk layer containing InAsSb.

6. The heterostructure according to claim 4, wherein the active area comprises quantum wells containing InAs and InAsSb.

7. The heterostructure according to claim 4, wherein the active area comprises a strained superlattice containing GaInAs and InAsSb.

8. A light-emitting diode, comprising:

at least one light-emitting diode (LED) chip which is formed on the basis of the heterostructure according to claim 2 and which comprises a first contact arranged on the substrate side and a second contact arranged on the active layer side.

9. A light-emitting diode, comprising: at least one light-emitting diode (LED) chip which is formed on the basis of the heterostructure according to any one of claims 4-7 and which comprises a first contact arranged on the barrier layer side and a second contact arranged on the substrate side.

10. The light-emitting diode according to claim 8 or 9, wherein the first contact is continuous, and the second contact has a partially covered surface.

11. The light-emitting diode according to any one of claims 8 -10, wherein the second contact is round-shaped or ring-shaped.

12. The light-emitting diode according to any one of claims 8-11, wherein the contacts comprise a four-layer Cr/Au/Ni/Au system.

13. A photodiode comprising: at least one photodiode chip which is formed on the basis of the heterostructure according to any one of claims 4-7 and which comprises two contacts, wherein one of the contacts is arranged on the substrate side, and the other contact is arranged on the barrier layer side.

14. The photodiode according to claim 13, wherein one of the contacts is configured to have a partially covered surface, and the other contact is configured continuous.

15. The photodiode according to claim 13 or 14, wherein one of the contacts is ring- shaped.

16. The photodiode according to any one of claims 13-15, wherein the contacts comprise a four-layer Cr/Au/Ni/Au system.

17. A method of producing the light-emitting diode according to any one of claims 8-12, the method including:

providing the heterostructure according to any one of claims 2 and 4-7;
forming two contacts on opposite sides of the heterostructure;
splitting the heterostructure with the contacts formed thereon to form light-emitting diode (LED) chips.

18. A method of producing the photodiode of any one of claims 13-16, the method including:

providing the heterostructure according to any one of claims 4-7;
forming two contacts on opposite sides of the heterostructure;

splitting the heterostructure with the contacts formed thereon to form photodiode chips.

19. A light-emitting diode comprising: at least one light-emitting diode (LED) chip which is formed on the basis of the heterostructure according to any one of claims 2, 4-7 and which comprises at least two contacts arranged on a LED side opposite to a LED emitting side.

20. A method of producing the light-emitting diode according to claim 19, the method including:

   providing the heterostructure according to claim 2 or to any one of claims 4-7,
   forming at least two contacts on the substrate side or at least two contacts on the barrier layer side,
   splitting the heterostructure with the contacts formed thereon to form light-emitting diode (LED) chips.

21. A photodiode comprising: at least one photodiode chip which is formed on the basis of the heterostructure according to any one of claims 4-7 and which comprises at least two contacts arranged on a side of the photodiode opposite to a radiation-receiving side of the photodiode.

22. A method of producing the photodiode of claim 21, the method including:

   providing the heterostructure according to any one of claims 4-7,
   forming at least two contacts on the barrier layer side or at least two contacts on the substrate side,
   splitting the heterostructure with the contacts formed thereon to form photodiode chips.

FIG. 1

FIG. 2

FIG. 3

FIG. 4

FIG. 5

FIG. 6

FIG. 7

## INTERNATIONAL SEARCH REPORT

International application No.

PCT/RU 2013/000796

**A. CLASSIFICATION OF SUBJECT MATTER** *H01L 21/205 (2006.01)* *H01L 31/0304 (2006.01)*
*H01L 33/30 (2010.01)* *H01L 31/18 (2006.01)*

According to International Patent Classification (IPC) or to both national classification and IPC

**B. FIELDS SEARCHED**

Minimum documentation searched (classification system followed by classification symbols)
H01L 21/00, 21/02, 21/04, 21/18, 21/20, 21/208, 21/77, 21/78, 31/00, 31/02, 31/0256, 31/0264, 31/0304, 31/18, 33/00, 33/12, 33/30

Documentation searched other than minimum documentation to the extent that such documents are included in the fields searched

Electronic data base consulted during the international search (name of data base and, where practicable, search terms used)

PatSearch (RUPTO internal), USPTO, PAJ, Esp@cenet, DWPI, EAPATIS, PATENTSCOPE

**C. DOCUMENTS CONSIDERED TO BE RELEVANT**

| Category* | Citation of document, with indication, where appropriate, of the relevant passages | Relevant to claim No. |
|---|---|---|
| A | ASTAKHOVA A. P. et al. Moshchnye svetodiody na osnove geterostruktur InAs/InAsSbP dlia spektroskopii metana ($\lambda \approx 3.3$ mkm). Fizika i tekhnika poluprovodnikov, 2010, vol. 44, vyp. 2, p. 278-282 | 1-22 |
| A | US 6108360 A (MANIJEH RAZEGHI) 22.08.2000 | 1-22 |
| A | RU 73126 U1 (OBSHCHESTVO S OGRANICHENNOI OTVETSTVENNOSTJU "AIBI") 10.05.2008 | 1-22 |
| A | RU 2286618 C2 (MATVEEV BORIS ANATOLEVICH) 27.10.2006 | 1-22 |

☐ Further documents are listed in the continuation of Box C. ☐ See patent family annex.

| | | | |
|---|---|---|---|
| * | Special categories of cited documents: | "T" | later document published after the international filing date or priority date and not in conflict with the application but cited to understand the principle or theory underlying the invention |
| "A" | document defining the general state of the art which is not considered to be of particular relevance | | |
| "E" | earlier application or patent but published on or after the international filing date | "X" | document of particular relevance; the claimed invention cannot be considered novel or cannot be considered to involve an inventive step when the document is taken alone |
| "L" | document which may throw doubts on priority claim(s) or which is cited to establish the publication date of another citation or other special reason (as specified) | "Y" | document of particular relevance; the claimed invention cannot be considered to involve an inventive step when the document is combined with one or more other such documents, such combination being obvious to a person skilled in the art |
| "O" | document referring to an oral disclosure, use, exhibition or other means | | |
| "P" | document published prior to the international filing date but later than the priority date claimed | "&" | document member of the same patent family |

| Date of the actual completion of the international search | Date of mailing of the international search report |
|---|---|
| 24 January 2014 (24.01.2014) | 27 February 2014 (27.02.2014) |

| Name and mailing address of the ISA/ | Authorized officer |
|---|---|
| RU | |
| Facsimile No. | Telephone No. |

Form PCT/ISA/210 (second sheet) (July 2009)

## REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

### Patent documents cited in the description

- RU 2286618

### Non-patent literature cited in the description

- **T.N. DANILOVA ; A.N. IMENKOV ; K.D. MOISEEV ; I.N. TIMCHENKO ; YU.P. YAKOVLEV.** Light-emitting diodes based on InAsSbP for the spectral range of 2.6 - 3.0 $\mu$m (T = 300K). *Letters to the Technical Physics Journal,* 1994, vol. 20 (10), 20-24
- **V.V. ROMANOV ; E.V. IVANOV ; A.N. IMENKOV ; N.M. KOLCHANOVA ; K.D. MOISEEV ; N.D. STOYANOV ; YU.P. YAKOVLEV.** Light-emitting diodes based on InAsSbP limiting composition solid solutions for spectral range of 2.6 - 2.8 $\mu$m. *Letters to the Technical Physics Journal,* 2001, vol. 27 (14), 8087
- **A.P. ASTAKHOVA ; A.S. GOLOVIN ; N.D. ILYINSKAYA ; K.V. KALININA ; S.S. KIZHAEV ; O.YU. SEREBRENNIKOVA ; N.D. STOYANOV ; ZS.J. HORVATH ; YU.P. YAKOVLEV.** Powerful light-emitting diodes based on InAs/InAsSbP heterostructures for methane spectroscopy ($\lambda \approx 3.3$ $\mu$m). *Semiconductor physics and technology,* 2010, vol. 44 (2), 278284